# EUROPÄISCHE PATENTANMELDUNG

(11) **EP 4 727 329 A2**
(43) Veröffentlichungstag der Anmeldung: **15.04.2026**
(21) Anmeldenummer: 25199605.4
(22) Anmeldetag: 02.09.2025
(51) Int. Cl.: H10W 76/15, H10W 76/18, H10W 76/47, H10W 76/63

(54) **HALBLEITERMODUL**

(30) Priorität: 23.09.2024 DE 102024127418
(71) Anmelder: Infineon Technologies Bipolar GmbH & Co. KG, 59581 Warstein (DE)
(72) Erfinder: SCHULTE, Markus, 59519 Möhnesee (DE); BARTHELMESS, Reiner, 59494 Soest (DE); KRAUSE, Elmar, 59581 Warstein (DE)
(74) Vertreter: Westphal, Mussgnug & Partner, Patentanwälte mbB

(57) **Zusammenfassung**

Ein Halbleitermodul (100) weist auf: ein Gehäuse (50), eine Bodenplatte (30), welche einen Boden des Gehäuses (50) bildet eine in dem Gehäuse (50) und auf der Bodenplatte (30) angeordnete Bauelementanordnung (10); ein Klemmsystem mit einer Klemmplatte (40) und einem oder mehreren Befestigungselementen (42), wobei die Bauelementanordnung (10) zwischen der Klemmplatte (40) und der Bodenplatte (30) angeordnet ist, und das eine oder die mehreren Befestigungselemente (42) dazu ausgebildet sind, die Klemmplatte (40) in Richtung der Bodenplatte (30) zu ziehen, so dass die Bauelementanordnung (10) mittels der Klemmplatte (40) gegen die Bodenplatte (30) gedrückt wird; ein elektrisch isolierendes Abdeckelement (70), welches einen Deckel und Seitenwände aufweist, wobei sich der Deckel wenigstens teilweise über eine von der Bauelementanordnung (10) abgewandte Seite der Klemmplatte (40) erstreckt, und sich die Seitenwände von dem Deckel in Richtung der Bodenplatte (30) erstrecken; und eine elektrisch isolierende Vergussmasse (60), welche die Bodenplatte (30) bedeckt und das Gehäuse (50) teilweise füllt, wobei sich die Seitenwände des elektrisch isolierenden Abdeckelements (70) in Richtung der Bodenplatte (30) teilweise in die elektrisch isolierende Vergussmasse (60) hinein erstrecken, und ein der Bodenplatte zugewandter unterer Teil der Bauelementanordnung (10) von der elektrisch isolierenden Vergussmasse (60) bedeckt ist, und ein oberer Teil der Bauelementanordnung (10), welcher aus der elektrisch isolierenden Vergussmasse (60) herausragt, wenigstens teilweise von den Seitenwänden des elektrisch isolierenden Abdeckelements (70) umgeben ist.

## Beschreibung

Die vorliegende Erfindung betrifft Halbleiterbmodule, insbesondere Halbleitermodule mit einem oder mehreren druckkontaktierten Bauelementen.

Halbleitermodule weisen in der Regel ein oder mehrere in einem Gehäuse angeordnete Bauelementanordnungen auf. Die Bauelementanordnungen können dabei beispielsweise druckkontaktiert werden. Eine druckkontaktierte Bauelementanordnung wird mittels einer entsprechenden Anordnung gegen eine Bodenplatte gepresst, welche meist einen Boden des Gehäuses bildet. Derartige Bauelementanordnungen weisen meist ein Halbleiterbauelement (z.B. eine Diode, einen Transistor oder einen Thyristor), sowie oberhalb und unterhalb des Halbleiterbauelements angeordnete Druckplatten auf. Zwischen dem Halbleiterbauelement und den Druckplatten sind zudem flache Anschlussterminals angeordnet. Die elektrische Kontaktierung des Halbleiterbauelements mittels der flachen Anschlussterminals wird durch den auf die Bauelementanordnung ausgeübten Druck sichergestellt. Die Anschlussterminals werden zur externen Kontaktierung aus dem Gehäuse herausgeführt. Um ungewollte elektrische Überschläge zwischen einer Bauelementanordnung und anderen Komponenten eines Halbleitermoduls (z.B. Anschlussterminals) zu verhindern, wird das Gehäuse in der Regel vollständig mit einer elektrisch isolierenden Vergussmasse gefüllt. Wird ein Gehäuse vollständig mit Vergussmasse gefüllt, besteht die Gefahr, dass die Vergussmasse ungewollt aus dem Gehäuse ausläuft, beispielsweise wenn aufgrund von Dosiertoleranzen eine zu große Menge an Vergussmasse in das Gehäuse gefüllt wird. Auch ein ungewolltes Auslaufen aufgrund thermischer Ausdehnung der Vergussmasse nach dem Einfüllen ist beispielsweise möglich. Entsprechende Vergussmassen sind zudem auch verhältnismäßig teuer, so dass die Gesamtkosten für entsprechende Halbleitermodule hoch sind.

Die Aufgabe besteht darin, ein isolationsfestes Halbleitermodul mit wenigstens einer druckkontaktierten Bauelementanordnung zur Verfügung zu stellen, welches zuverlässig gegen Auslaufen der Vergussmasse geschützt ist und welches zudem möglichst kostengünstig herstellbar ist.

Ein Halbleitermodul weist auf: ein Gehäuse, eine Bodenplatte, welche einen Boden des Gehäuses bildet, eine in dem Gehäuse und auf der Bodenplatte angeordnete Bauelementanordnung; ein Klemmsystem mit einer Klemmplatte und einem oder mehreren Befestigungselementen, wobei die Bauelementanordnung zwischen der Klemmplatte und der Bodenplatte angeordnet ist, und das eine oder die mehreren Befestigungselemente dazu ausgebildet sind, die Klemmplatte in Richtung der Bodenplatte zu ziehen, so dass die Bauelementanordnung mittels der Klemmplatte gegen die Bodenplatte gedrückt wird; ein elektrisch isolierendes Abdeckelement, welches einen Deckel und Seitenwände aufweist, wobei sich der Deckel wenigstens teilweise über eine von der Bauelementanordnung abgewandte Seite der Klemmplatte erstreckt, und sich die Seitenwände von dem Deckel in Richtung der Bodenplatte erstrecken; und eine elektrisch isolierende Vergussmasse, welche die Bodenplatte bedeckt und das Gehäuse teilweise füllt, wobei sich die Seitenwände des elektrisch isolierenden Abdeckelements in Richtung der Bodenplatte teilweise in die elektrisch isolierende Vergussmasse hinein erstrecken, und ein der Bodenplatte zugewandter unterer Teil der Bauelementanordnung von der elektrisch isolierenden Vergussmasse bedeckt ist, und ein oberer Teil der Bauelementanordnung, welcher aus der elektrisch isolierenden Vergussmasse herausragt, wenigstens teilweise von den Seitenwänden des elektrisch isolierenden Abdeckelements umgeben ist.

Ein Verfahren zum Herstellen eines Halbleitermoduls weist auf: Anordnen einer Bauelementanordnung auf einer Bodenplatte, wobei die Bodenplatte den Boden eines Gehäuses bildet; Anordnen einer Klemmplatte eines Klemmsystems auf der Bauelementanordnung, so dass die Bauelementanordnung zwischen der Klemmplatte und der Bodenplatte angeordnet ist; Befestigen der Klemmplatte an der Bodenplatte mittels einem oder mehrerer Befestigungselemente derart, dass das eine oder die mehreren Befestigungselemente die Klemmplatte in Richtung der Bodenplatte ziehen, so dass die Bauelementanordnung mittels der Klemmplatte gegen die Bodenplatte gedrückt wird; Anordnen eines elektrisch isolierenden Abdeckelements über der Bauelementanordnung und dem Klemmsystem, wobei das elektrisch isolierende Abdeckelement einen Deckel und Seitenwände aufweist, wobei das elektrisch isolierende Abdeckelement derart angeordnet wird, dass sich der Deckel wenigstens teilweise über eine von der Bauelementanordnung abgewandte Seite der Klemmplatte erstreckt, und sich die Seitenwände von dem Deckel in Richtung der Bodenplatte erstrecken; und Einfüllen einer elektrisch isolierenden Vergussmasse in das Gehäuse, derart, dass diese die Bodenplatte bedeckt und das Gehäuse teilweise füllt, wobei sich die Seitenwände des elektrisch isolierenden Abdeckelements in Richtung der Bodenplatte teilweise in die elektrisch isolierende Vergussmasse hinein erstrecken, und ein der Bodenplatte zugewandter unterer Teil der Bauelementanordnung von der elektrisch isolierenden Vergussmasse bedeckt ist, und ein oberer Teil der Bauelementanordnung, welcher aus der elektrisch isolierenden Vergussmasse herausragt, wenigstens teilweise von den Seitenwänden des elektrisch isolierenden Abdeckelements umgeben ist.

Die Erfindung wird nachfolgend anhand von Beispielen und unter Bezugnahme auf die Figuren näher erläutert. Dabei bezeichnen gleiche Bezugszeichen gleiche Elemente. Die Darstellung in den Figuren ist nicht maßstäblich.
Figur 1 zeigt schematisch einen Querschnitt durch ein Halbleitermodul mit einer druckkontaktierten Bauelementanordnung;
Figur 2 zeigt schematisch einen Querschnitt durch ein Halbleitermodul mit einer druckkontaktierten Bauelementanordnung in größerem Detail;
Figur 3 zeigt schematisch in einer dreidimensionalen Ansicht eine druckkontaktierte Bauelementanordnung auf einer Bodenplatte;
Figur 4 zeigt schematisch in einer dreidimensionalen Ansicht zwei druckkontaktierte Bauelementanordnungen auf einer Bodenplatte;
Figur 5 zeigt schematisch in einer dreidimensionalen Ansicht zwei druckkontaktierte Bauelementanordnungen auf einer Bodenplatte in einem Gehäuse ohne Gehäusedeckel;
Figur 6 zeigt schematisch eine dreidimensionale Ansicht eines Halbleitermoduls mit geschlossenem Gehäuse;
Figur 7 zeigt schematisch einen Querschnitt durch ein Halbleitermodul gemäß einem Beispiel;
Figur 8 zeigt schematisch in einer dreidimensionalen Ansicht zwei druckkontaktierte Bauelementanordnungen auf einer Bodenplatte gemäß einem weiteren Beispiel;
Figur 9 zeigt schematisch einen Querschnitt durch ein Halbleitermodul gemäß einem weiteren Beispiel.

In der nachfolgenden ausführlichen Beschreibung wird anhand konkreter Beispiele veranschaulicht, wie die Erfindung realisiert werden kann. Es versteht sich, dass die Merkmale der verschiedenen hierin beschriebenen Beispiele, sofern nicht anderweitig erwähnt, miteinander kombiniert werden können. Sofern bestimmte Elemente als "erstes Element", "zweites Element",... oder dergleichen bezeichnet werden, dient die Angabe "erstes", "zweites",... lediglich dazu, verschiedene Elemente voneinander zu unterscheiden. Eine Reihenfolge oder Aufzählung ist mit dieser Angabe nicht verbunden. Das bedeutet, dass beispielsweise ein "zweites Element" auch dann vorhanden sein kann, wenn kein "erstes Element" vorhanden ist.

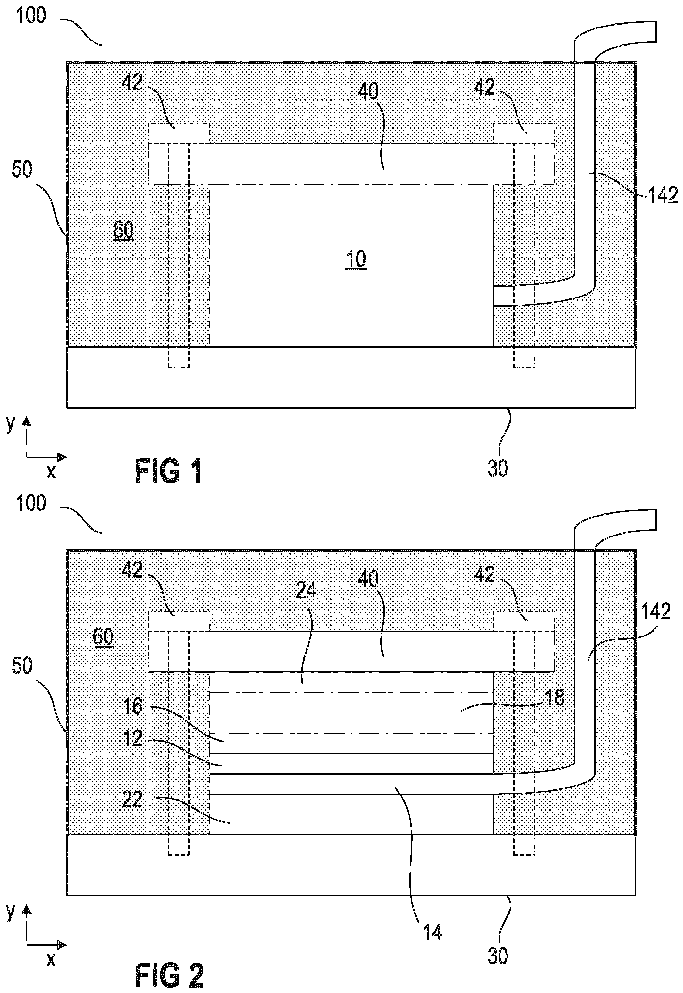

Figur 1 zeigt schematisch einen Querschnitt durch ein Halbleitermodul mit einer druckkontaktierten Bauelementanordnung. Das Halbleitermodul 100 weist ein Gehäuse 50 und eine Bodenplatte 30 auf, welche einen Boden des Gehäuses 50 bildet. Das Halbleitermodul 100 weist weiterhin eine in dem Gehäuse 50 und auf der Bodenplatte 30 angeordnete Bauelementanordnung 10 sowie ein Klemmsystem mit einer Klemmplatte 40 und einem oder mehreren Befestigungselementen 42 auf. Die Bauelementanordnung 10 ist zwischen der Klemmplatte 40 und der Bodenplatte 30 angeordnet. Das eine oder die mehreren Befestigungselemente 42 sind dazu ausgebildet, die Klemmplatte 40 in Richtung der Bodenplatte 30 zu ziehen, so dass die Bauelementanordnung 10 mittels der Klemmplatte 40 gegen die Bodenplatte 30 gedrückt wird. Auf diese Weise kann eine zuverlässige elektrische Kontaktierung der Bauelementanordnung 10 erreicht werden.

Die Bauelementanordnung 10 kann verschiedene, übereinander angeordnete Elemente aufweisen. Dies wird unter Bezugnahme auf Figur 2 im Weiteren beispielhaft näher erläutert. Die Bauelementanordnung 10 weist in der Regel ein Halbleiterbauelement 12 (z.B. eine Diode, einen Transistor oder einen Thyristor) auf. Die Bauelementanordnung 10 kann weiterhin eine auf einer ersten Seite des Halbleiterbauelements 12 angeordnete erste Kontaktscheibe 14 sowie eine auf einer zweiten, der ersten gegenüberliegenden Seite des Halbleiterbauelements 12 angeordnete zweite Kontaktscheibe 16 aufweisen, wobei die erste Kontaktscheibe 14 dazu ausgebildet ist das Halbleiterbauelement 12 von der ersten Seite elektrisch zu kontaktieren, und die zweite Kontaktscheibe 16 dazu ausgebildet ist das Halbleiterbauelement 12 von der zweiten Seite elektrisch zu kontaktieren. Das Halbleiterbauelement 12 weist in der Regel zwei oder mehr Metallisierungsflächen zur elektrischen Kontaktierung auf. Auf der Ober- und der Unterseite des Halbleiterbauelements 12 ist dabei jeweils wenigstens eine Metallisierungsfläche angeordnet. Durch die erste und die zweite Kontaktscheibe 14, 16 wird das Halbleiterbauelement 12, insbesondere die Metallisierungsflächen, von zwei Seiten her elektrisch kontaktiert. Wie oben beschrieben wird die Bauelementanordnung 10 mittels der Klemmplatte 40 gegen die Bodenplatte 30 gedrückt. Dadurch werden die erste und die zweite Kontaktscheibe 14, 16 jeweils gegen das Halbleiterbauelement 12 gedrückt, und so ein ausreichender Kontakt zwischen den Kontaktscheiben 14, 16 und dem Halbleiterbauelement 12 sichergestellt.

Wie beispielhaft in Figur 2 dargestellt, kann die Bauelementanordnung 10 weiterhin eine auf der ersten Seite des Halbleiterbauelements 12 angeordnete Isolierscheibe 22 aufweisen, wobei die erste Kontaktscheibe 14 zwischen der Isolierscheibe 22 und dem Halbleiterbauelement 12 angeordnet ist.. Diese Isolierscheibe 22 besteht aus einem elektrisch isolierenden Material und dient dazu, die erste Kontaktscheibe 14 elektrisch von der Bodenplatte 30 zu isolieren. Weiterhin kann die Bauelementanordnung 10 eine auf der zweiten Seite des Halbleiterbauelements 12 angeordnete Druckplatte 24 aufweisen, wobei die zweite Kontaktscheibe 16 zwischen der Druckplatte 24 und dem Halbleiterbauelement 12 angeordnet ist. Diese Druckplatte 24 dient dazu, den von der Klemmplatte 40 ausgeübten Druck auf die zwischen der Klemmplatte 40 und der Bodenplatte 30 angeordneten Elemente zu übertragen. Das heißt, die erste Kontaktscheibe 14, die zweite Kontaktscheibe 16 und das Halbleiterbauelement 12 sind zwischen der Isolierscheibe 22 und der Druckplatte 24 angeordnet. Die erste und die zweite Kontaktscheibe 14, 16 werden durch den mittels des Klemmsystems ausgeübten Druck zur elektrischen Kontaktierung jeweils gegen das Halbleiterbauelement 12 gepresst.

Weiterhin Bezug nehmend auf Figur 2, kann die Bauelementanordnung 10 weiterhin ein Kontaktelement 18 aufweisen, das ebenfalls dazu ausgebildet ist das Halbleiterbauelement 12 elektrisch zu kontaktieren und welches zwischen der Druckplatte 24 und der zweiten Kontaktscheibe 16 angeordnet ist. Ein Kontaktelement 18 wird beispielsweise dann benötigt, wenn das Halbleiterbauelement 12 einen Transistor oder einen Thyristor und somit drei zu kontaktierende Metallisierungsflächen aufweist. Ein Kontaktelement 18 kann beispielsweise eine Scheibe aus einem elektrisch isolierenden Material aufweisen um eine elektrische Isolierung zu der zweiten Kontaktscheibe 16, welche in der Regel mit einem unterschiedlichen elektrischen Potential verbunden ist, zu gewährleisten. Durch die Scheibe aus elektrisch isolierendem Material können elektrische Leitungen oder Verbindungen verlaufen, um dem Halbleiterbauelement 12 Signale (z.B. Gate-Steuersignale) bereitzustellen. Die zweite Kontaktscheibe 16 kann beispielsweise eine oder mehrere Öffnungen aufweisen, durch welche ein elektrischer Kontakt zwischen dem Kontaktelement 18 und dem Halbleiterbauelement 12 hergestellt werden kann.

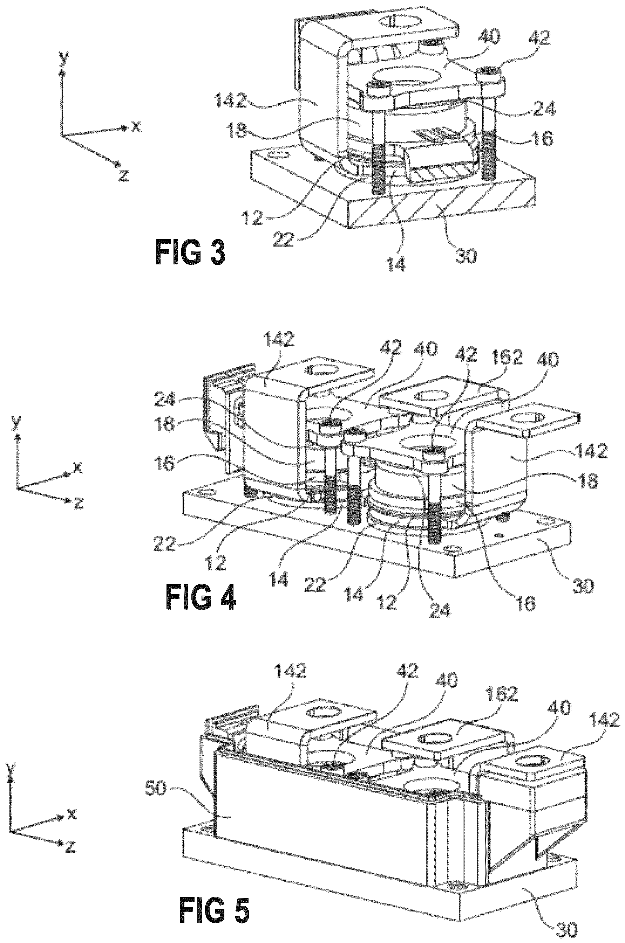

Wie weiterhin in den Figuren 1 und 2 beispielhaft dargestellt ist, kann das Halbleitermodul 100 weiterhin ein erstes Anschlussterminal 142 aufweisen, welches ein erstes Ende und ein zweites, dem ersten gegenüberliegendes Ende aufweist. Das erste Ende ist mit der ersten Kontaktscheibe 14 verbunden. Von der ersten Kontaktscheibe 14 erstreckt sich das erste Anschlussterminal 142 durch das Gehäuse 50, und das zweite Ende des ersten Anschlussterminals 142 ragt auf einer der Bodenplatte 30 abgewandten Seite aus dem Gehäuse 50 heraus. Dies ist auch beispielhaft in der dreidimensionalen Ansicht eines Halbleitermoduls in Figur 3 schematisch dargestellt, wobei in der in Figur 3 dargestellten Ansicht das Gehäuse 50 der Übersichtlichkeit halber nicht gezeigt wird, da dies andere Elemente des Halbleitermoduls 100 verdecken würde.

Das erste Anschlussterminal 142 ist dabei in horizontaler Richtung x beabstandet zu der Bauelementanordnung 10 angeordnet. Ein Abstand zwischen dem ersten Anschlussterminal 142 und der Bauelementanordnung 10 kann beispielsweise mehrere Millimeter bis zu wenige Zentimeter betragen. Die erste Kontaktscheibe 14 kann über das erste Anschlussterminal 142 mit einem ersten elektrischen Potential verbunden werden. Die zweite Kontaktscheibe 16 wird in der Regel mit einem zweiten elektrischen Potential verbunden, welches sich von dem ersten elektrischen Potential unterscheidet. Um ungewollte elektrische Überschläge zwischen dem ersten Anschlussterminal 142 und anderen Komponenten der Bauelementanordnung 10 (z.B. der zweiten Kontaktscheibe 16) zu verhindern, wird das Gehäuse 50, wie in den Figuren 1 und 2 beispielhaft dargestellt, in der Regel vollständig mit einer elektrisch isolierenden Vergussmasse 60 gefüllt. Eine vollständige Verfüllung des Gehäuses 50 mit Vergussmasse 60 ist dabei in der Regel im Hinblick auf Luft- und Kriechstrecken in dem Halbleitermodul 100 erforderlich. Wird ein Gehäuse 50 vollständig mit Vergussmasse 60 gefüllt, besteht jedoch die Gefahr, dass die Vergussmasse 60 ungewollt aus dem Gehäuse 50 ausläuft. Beispielsweise kann aufgrund von Dosiertoleranzen ungewollt eine zu große Menge der Vergussmasse 60 in das Gehäuse 50 eingefüllt werden. Auch ein ungewolltes Auslaufen aufgrund thermischer Ausdehnung der Vergussmasse 60 nach dem Einfüllen ist beispielsweise möglich (z.B. während des Betriebs des Halbleitermoduls). Entsprechende Vergussmassen sind zudem auch verhältnismäßig teuer, so dass die Gesamtkosten für entsprechende Halbleitermodule 100 hoch sind.

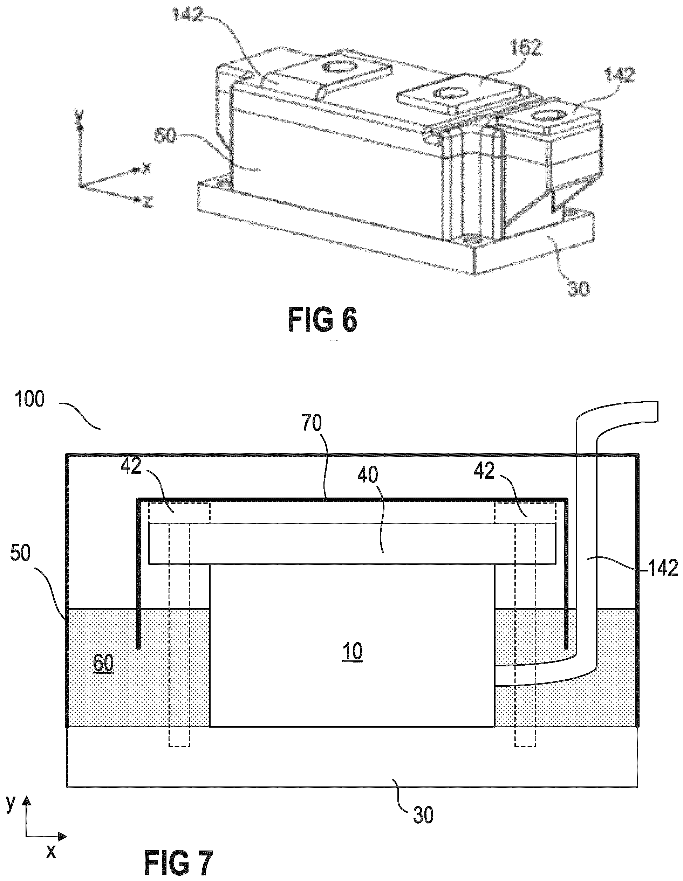

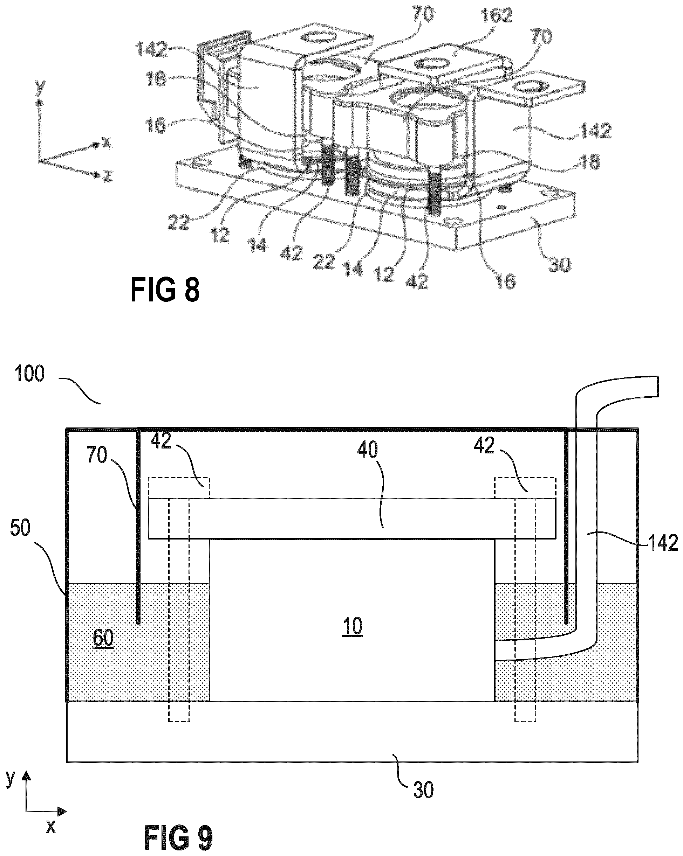

Nun Bezug nehmend auf die Figuren 7 und 9, weist ein Halbleitermodul 100 gemäß Ausführungsformen der Erfindung, zusätzlich zu den in Bezug auf Figur 1 beschriebenen Elementen, weiterhin ein elektrisch isolierendes Abdeckelement 70 auf, welches einen Deckel und Seitenwände aufweist. Der Deckel des elektrisch isolierenden Abdeckelements 70 erstreckt sich dabei wenigstens teilweise über eine von der Bauelementanordnung 10 abgewandte Seite der Klemmplatte 40. Das heißt, die Klemmplatte 40 ist zwischen dem elektrisch isolierenden Abdeckelement 70 und der Bauelementanordnung 10 angeordnet. Die Seitenwände des elektrisch isolierenden Abdeckelements 70 erstrecken sich von dem Deckel in Richtung der Bodenplatte 30. Das Halbleitermodul weist weiterhin, wie oben beschrieben, eine elektrisch isolierende Vergussmasse 60 auf, welche die Bodenplatte 30 bedeckt und das Gehäuse 50 jedoch nur teilweise füllt. Die Seitenwände des elektrisch isolierenden Abdeckelements 70 erstrecken sich in Richtung der Bodenplatte 30 teilweise in die elektrisch isolierende Vergussmasse 60 hinein. Ein der Bodenplatte 30 zugewandter unterer Teil der Bauelementanordnung 10 ist von der elektrisch isolierenden Vergussmasse 60 bedeckt, und ein oberer Teil der Bauelementanordnung 10, welcher aus der elektrisch isolierenden Vergussmasse 60 herausragt, ist wenigstens teilweise von den Seitenwänden des elektrisch isolierenden Abdeckelements 70 umgeben.

Das elektrisch isolierende Abdeckelement 70 bildet daher im Wesentlichen eine Art Haube über der Bauelementanordnung 10 und dem Klemmsystem. Die elektrisch isolierende Vergussmasse 60 wird, im Gegensatz zu den Anordnungen der Figuren 1 und 2, nicht bis zum oberen Rand des Gehäuses 50 eingefüllt, sondern füllt das Gehäuse 50 nur teilweise. Dadurch werden die oben beschriebenen Nachteile eines vollständig mit Vergussmasse 60 gefüllten Gehäuses (z.B. ungewolltes Überlaufen, hohe Kosten) vermieden. Das elektrisch isolierende Abdeckelement 70, insbesondere dessen Seitenwände, erstrecken sich jedoch derart von oben in die Vergussmasse 60 hinein, dass Luft- und Kriechstrecken im Gehäuse wirksam unterbrochen oder verlängert werden.

Das elektrisch isolierende Abdeckelement 70 kann dabei, wie in Figur 7 dargestellt, beispielsweise ein separates Element sein, welches einfach auf die Bauelementanordnung 10 und das Klemmsystem aufgeschoben werden kann. Das elektrisch isolierende Abdeckelement 70 kann dabei lediglich auf der Bauelementanordnung 10 und dem Klemmsystem aufliegen und muss nicht zwangsläufig fest mit diesen verbunden werden. Ein Verschieben des elektrisch isolierenden Abdeckelements 70 in horizontaler Richtung x wird beispielsweise durch die Seitenwände verhindert. Da sich das elektrisch isolierende Abdeckelement 70 in die Vergussmasse 60 hinein erstreckt, wird auch eine ungewollte Bewegung in vertikaler Richtung y verhindert. Die Vergussmasse 60 ist grundsätzlich ein ausgehärteter Weich- oder Hartverguss. Die Vergussmasse 60 wird dabei erst ausgehärtet, nachdem das elektrisch isolierende Abdeckelement 70 auf der Bauelementanordnung 10 und dem Klemmsystem angeordnet wurde. Dadurch werden die unteren Enden der Seitenwände, welche sich in die Vergussmasse 60 hinein erstrecken, fest von der Vergussmasse 60 umschlossen und können nur unter Aufbringen einer entsprechend großen Kraft wieder aus der Vergussmasse 60 herausgezogen werden.

Das elektrisch isolierende Abdeckelement 70 kann, wie in Figur 7 gezeigt, auf der Bauelementanordnung 10 und dem Klemmsystem direkt aufliegen. Das heißt, das elektrisch isolierende Abdeckelement 70 kann vertikal beabstandet von dem Gehäusedeckel angeordnet sein. Gemäß einer weiteren Ausführungsform ist es jedoch alternativ möglich, dass der Deckel des elektrisch isolierenden Abdeckelements 70 an dem Gehäusedeckel befestigt ist. Das elektrisch isolierende Abdeckelement 70 kann beispielsweise an dem Gehäusedeckel angeklebt oder auf andere geeignete Art und Weise mit diesem verbunden werden. Gemäß einer weiteren Ausführungsform, wie beispielsweise in Figur 9 dargestellt, kann der Deckel des elektrisch isolierenden Abdeckelements 70 auch durch einen Abschnitt des Gehäusedeckels gebildet werden. Das heißt, das elektrisch isolierende Abdeckelement 70 kann zumindest teilweise durch den Gehäusedeckel gebildet werden. Die Seitenwände erstrecken sich in diesem Beispiel von dem Gehäusedeckel in vertikaler Richtung y in die Vergussmasse 60 hinein. Die Seitenwände des elektrisch isolierenden Abdeckelements 70 können dabei beispielsweise auf geeignete Art und Weise an dem Gehäusedeckel befestigt werden. Alternativ ist es auch möglich das Gehäuse 50, oder wenigstens den Gehäusedeckel, zusammen mit den Seitenwänden des elektrisch isolierenden Abdeckelements 70 in einem Spritzgussverfahren (oder anderem geeigneten Verfahren) als ein einstückiges Element herzustellen.

Die Seitenwände des elektrisch isolierenden Abdeckelements 70 können sich in allen beschriebenen Beispielen beispielsweise derart in die elektrisch isolierende Vergussmasse 60 hineinerstrecken, dass die Seitenwände zu weniger als 50%, zu weniger als 25% oder zu weniger als 15% von der elektrisch isolierenden Vergussmasse 60 bedeckt sind. Eine sehr geringe Bedeckung der Seitenwände mit Vergussmasse 60 (z.B. 1 bis 5%) ist grundsätzlich bereits ausreichend, um zuverlässig Luft- und Kriechstrecken zwischen der Bauelementanordnung 10 und anderen in dem Gehäuse 50 angeordneten Elementen zu unterbrechen.

Die elektrisch isolierende Vergussmasse 60 kann das Gehäuse 50 beispielsweise zu 80% oder weniger, zu 75% oder weniger, oder zu 65% oder weniger füllen. Durch das Vorsehen des elektrisch isolierenden Abdeckelements 70 ist grundsätzlich eine signifikante Reduzierung des Fülllevels der Vergussmasse 60 möglich. Wie oben beschrieben, kann die Bauelementanordnung 10 ein Halbleiterbauelement 12, eine auf einer ersten Seite des Halbleiterbauelements 12 angeordnete erste Kontaktscheibe 14, die dazu ausgebildet ist das Halbleiterbauelement 12 (von einer ersten Seite) elektrisch zu kontaktieren, eine auf einer zweiten, der ersten gegenüberliegenden Seite des Halbleiterbauelements 12 angeordnete zweite Kontaktscheibe 16, die dazu ausgebildet ist das Halbleiterbauelement 12 (von einer zweiten, der ersten gegenüberliegenden zweiten Seite) elektrisch zu kontaktieren, eine auf der ersten Seite des Halbleiterbauelements 12 angeordnete Isolierscheibe 22, und eine auf der zweiten Seite des Halbleiterbauelements 12 angeordnete Druckplatte 24 aufweisen, wobei die erste Kontaktscheibe 14, die zweite Kontaktscheibe 16 und das Halbleiterbauelement 12 zwischen der Isolierscheibe 22 und der Druckplatte 24 angeordnet sind. Die elektrisch isolierende Vergussmasse 60 kann dabei beispielsweise wenigstens die Isolierscheibe 22, die erste Kontaktscheibe 14, das Halbleiterbauelement 12, und die zweite Kontaktscheibe 16 bedecken. Auf diese Weise sind wenigstens die Strom führenden Elemente der Bauelementanordnung von der elektrisch isolierenden Vergussmasse 60 bedeckt. Weist eine Bauelementanordnung 10 weiterhin ein Kontaktelement 18 auf, so kann gemäß einer Ausführungsform auch das Kontaktelement 18, als weiteres, Strom führendes Element, von der elektrisch isolierenden Vergussmasse 60 bedeckt sein. Auf diese Weise können zuverlässig Luft- und Kriechstrecken zwischen der Bauelementanordnung 10 und anderen in dem Gehäuse 50 angeordneten Elementen unterbrochen werden.

Wie oben beschrieben, kann das Halbleitermodul wenigstens ein erstes Anschlussterminal 142 aufweisen, welches ein erstes Ende und ein zweites, dem ersten gegenüberliegendes zweites Ende aufweist, wobei das erste Ende mit der ersten Kontaktscheibe 14 verbunden ist, sich das erste Anschlussterminal 142 von der ersten Kontaktscheibe 14 durch das Gehäuse 50 erstreckt, und das zweite Ende auf einer der Bodenplatte 30 abgewandten Seite aus dem Gehäuse 50 herausragt. Das elektrisch isolierende Abdeckelement 70 (z.B. eine Seitenwand des elektrisch isolierenden Abdeckelements 70) kann zwischen der Bauelementanordnung 10 und dem ersten Anschlussterminal 142 angeordnet sein. Da die Vergussmasse 60 nicht das gesamte Gehäuse 50 füllt, werden in der beschriebenen Anordnung ungewollte elektrische Überschläge zwischen dem ersten Anschlussterminal 142 und anderen Komponenten der Bauelementanordnung 10 (z.B. der zweiten Kontaktscheibe 16) durch das elektrisch isolierende Abdeckelement 70 verhindert.

Ein oberer Teil der Bauelementanordnung 10, welcher aus der elektrisch isolierenden Vergussmasse 60 herausragt, kann wenigstens teilweise von den Seitenwänden des elektrisch isolierenden Abdeckelements 70 umgeben sein. Beispielsweise können Seitenwände insbesondere dort angeordnet sein, wo sich ein Anschlussterminal 142 in vertikaler Richtung y durch das Gehäuse 50 nach oben erstreckt. In anderen Abschnitten der Bauelementanordnung 10, in welchen keine anderen elektrisch leitenden Elemente in unmittelbarer Nähe der Bauelementanordnung 10 angeordnet sind, sind Seitenwände nicht zwangsläufig erforderlich. In solchen Fällen ist bei der Montage des Halbleitermoduls 100 jedoch darauf zu achten, dass das elektrisch isolierende Abdeckelement 70 korrekt angeordnet ist. Gemäß weiteren Ausführungsformen kann daher ein oberer Teil der Bauelementanordnung 10, welcher aus der elektrisch isolierenden Vergussmasse 60 herausragt, vollständig von den Seitenwänden des elektrisch isolierenden Abdeckelements 70 umgeben sein. Da der aus der Vergussmasse 60 herausragende Teil der Bauelementanordnung 10 somit von dem elektrisch isolierenden Abdeckelement 70 vollständig umschlossen ist, muss bei der Montage nicht auf eine korrekte Anordnung des elektrisch isolierenden Abdeckelements 70 geachtet werden. Dies kann daher die Montage vereinfachen. Das elektrisch isolierende Abdeckelement 70 kann aus einem geeigneten, elektrisch isolierenden Material bestehen. Beispielsweise kann das elektrisch isolierende Abdeckelement 70 aus Keramik oder Kunststoff bestehen.

Wie beispielsweise in der dreidimensionalen Ansicht eines Halbleitermoduls in Figur 8 dargestellt ist, kann der Deckel des elektrisch isolierenden Abdeckelements 70 eine Öffnung oder eine Vertiefung aufweisen. Wie ebenfalls in Figur 8 dargestellt ist, erstreckt sich das zweite Ende des ersten Anschlussterminals 142 welches aus dem Gehäuse 50 heraus ragt, beispielsweise in horizontaler Richtung x über die Bauelementanordnung 10. Das erste Anschlussterminal 142 kann auf diese Weise leicht von außerhalb des Gehäuses 50 kontaktiert werden. Das zweite Ende des ersten Anschlussterminals 142 kann beispielsweise eine Öffnung aufweisen. Das erste Anschlussterminal 142 kann mittels eines externen Anschlussterminals (nicht explizit dargestellt) kontaktiert werden. Die Anschlussterminals werden dabei häufig mittels einer Schraube, welche sich durch die Öffnung in dem ersten Anschlussterminal 142, und eine Öffnung in dem externen Anschlussterminal erstreckt miteinander verbunden und fest aufeinander gepresst, um einen guten elektrischen Kontakt zwischen den Anschlussterminals herzustellen. Dabei ist unter dem zweiten Ende des ersten Anschlussterminals 142, insbesondere zwischen dem zweiten Ende des ersten Anschlussterminals 142 und der Bauelementanordnung 10, häufig eine Mutter angeordnet, in welche sich die Schraube hinein erstreckt. Eine solche Mutter kann in einer in dem elektrisch isolierenden Abdeckelement 70 gebildeten Öffnung oder Vertiefung angeordnet sein. Dadurch kann das Halbleitermodul 100 kompakter implementiert werden.

Das anhand der Figuren 2, 3, 7 und 9 beschriebene Halbleitermodul mit einer einzigen Bauelementanordnung 10 ist dabei lediglich ein Beispiel. Ein Halbleitermodul kann grundsätzlich auch mehr als nur eine Bauelementanordnung 10 aufweisen. Dies ist beispielhaft in den Figuren 4, 5, 6 und 8 dargestellt. Die Figuren 4, 5, 6 und 8 zeigen dabei beispielhaft ein Halbleitermodul mit zwei Bauelementanordnungen 10. Grundsätzlich kann ein Halbleitermodul jedoch auch mehr als zwei Bauelementanordnungen 10 aufweisen. Jede der zwei oder mehr Bauelementanordnungen 10 weist in den gezeigten Beispielen dabei die in Bezug auf die Figuren 2 und 3 beschriebenen Elemente auf. Der besseren Übersichtlichkeit halber ist das Gehäuse 50 in Figur 4 nicht dargestellt. Die beiden Bauelementanordnungen 10 sind nebeneinander auf der Bodenplatte 30 angeordnet. In dem in Figur 4 dargestellten Beispiel ist die zweite Kontaktscheibe 16 der ersten Bauelementanordnung 10 elektrisch mit der ersten Kontaktscheibe 14 der zweiten Bauelementanordnung 10 verbunden. Beispielsweise kann sich ein elektrisch leitendes Verbindungselement zwischen den entsprechenden Kontaktscheiben 14, 16 der beiden Bauelementanordnungen 10 erstrecken. Die zweite Bauelementanordnung 10 weist zudem, zusätzlich zu dem mit der ersten Kontaktscheibe 14 verbundenen ersten Anschlussterminal 142, ein zweites Anschlussterminal 162 auf, welches ein erstes Ende und ein zweites, dem ersten gegenüberliegendes Ende aufweist. Das erste Ende ist dabei mit der zweiten Kontaktscheibe 16 der zweiten Bauelementanordnung 10 verbunden. Ähnlich wie in Bezug auf das erste Anschlussterminal 142 beschrieben, erstreckt sich das zweite Anschlussterminal 162 von der zweiten Kontaktscheibe 16 der zweiten Bauelementanordnung 10 durch das Gehäuse 50, und das zweite Ende ragt auf einer der Bodenplatte 30 abgewandten Seite aus dem Gehäuse 50 heraus. Über dieses zweite Anschlussterminal 162 kann die zweite Kontaktscheibe 16 der zweiten Bauelementanordnung 10 elektrisch von außerhalb des Gehäuses 50 (Gehäuse in Figur 4 nicht dargestellt) kontaktiert werden. Beispielsweise kann das erste Anschlussterminal 142 der ersten Bauelementanordnung 10 mit einem ersten elektrischen Potential verbunden werden (z.B. positives Potential). Das zweite Anschlussterminal 162 der zweiten Bauelementanordnung 10 kann beispielsweise mit einem zweiten elektrischen Potential (z.B. negatives Potential) verbunden werden, welches von dem ersten Potential verschieden ist. An dem ersten Anschlussterminal 142 der zweiten Bauelementanordnung 10 kann beispielsweise ein Ausgangspotential der Anordnung bereitgestellt werden.

Figur 5 zeigt die Anordnung der Figur 4 mit den Seitenwänden des Gehäuses 50, jedoch ohne Gehäusedeckel. Figur 6 zeigt die Anordnung mit komplett geschlossenem Gehäuse 50, aus welchen die ersten und zweiten Anschlussterminals 142, 162 zur elektrischen Kontaktierung herausragen. Die Figuren 4 und 5 zeigen dabei Anordnungen ohne elektrisch isolierende Abdeckelemente 70. In Figur 6 sind aufgrund des Gehäuses 50 die Elemente im Inneren des Gehäuses verdeckt. Figur 8 zeigt die Anordnung ohne Gehäuse, jedoch mit auf den Bauelementanordnungen 10 angeordneten elektrisch isolierenden Abdeckelementen 70. Die Seitenwände der in Figur 8 dargestellten elektrisch isolierenden Abdeckelemente 70 folgen im Wesentlichen der Form der jeweiligen Klemmplatte 40 sowie der Befestigungselemente 42. Die elektrisch isolierenden Abdeckelemente 70 haben dabei im gezeigten Beispiel eine im Wesentlichen quadratische Form, wobei an den jeweiligen Ecken Ausbuchtungen für die Befestigungselemente 42 vorgesehen sind. Dies ist jedoch lediglich ein Beispiel. Ein elektrisch isolierendes Abdeckelement 70 kann grundsätzlich jede beliebige Form aufweisen. Wie oben erläutert, können die Seitenwände eines elektrisch isolierenden Abdeckelements 70 auch nur abschnittsweise vorhanden sein, und die entsprechende Bauelementanordnung 10 somit nur teilweise umgeben. Die in Figur 8 dargestellten elektrisch isolierenden Abdeckelemente 70 weisen, wie oben beschrieben, in ihrem Deckel Öffnungen zur Aufnahme von Muttern auf. Derartige Öffnungen oder Vertiefungen sind jedoch lediglich optional.

Ein Verfahren zum Herstellen eines Halbleitermoduls 100 weist das Anordnen einer Bauelementanordnung 10 auf einer Bodenplatte 30 auf, wobei die Bodenplatte 30 den Boden eines Gehäuses 50 bildet. Das Verfahren weist weiterhin das Anordnen einer Klemmplatte 40 eines Klemmsystems auf der Bauelementanordnung 10 auf, so dass die Bauelementanordnung 10 zwischen der Klemmplatte 40 und der Bodenplatte 30 angeordnet ist. Weiterhin weist das Verfahren das Befestigen der Klemmplatte 40 an der Bodenplatte 30 mittels einem oder mehrerer Befestigungselemente 42 auf derart, dass das eine oder die mehreren Befestigungselemente 42 die Klemmplatte 40 in Richtung der Bodenplatte 30 ziehen, so dass die Bauelementanordnung 10 mittels der Klemmplatte 40 gegen die Bodenplatte 30 gedrückt wird. Das Verfahren weist zudem das Anordnen eines elektrisch isolierenden Abdeckelements 70 über der Bauelementanordnung 10 und dem Klemmsystem, wobei das elektrisch isolierende Abdeckelement 70 einen Deckel und Seitenwände aufweist, wobei das elektrisch isolierende Abdeckelement 70 derart angeordnet wird, dass sich der Deckel wenigstens teilweise über eine von der Bauelementanordnung 10 abgewandte Seite der Klemmplatte 40 erstreckt, und sich die Seitenwände von dem Deckel in Richtung der Bodenplatte 30 erstrecken, und das Einfüllen einer elektrisch isolierenden Vergussmasse 60 in das Gehäuse auf, derart, dass diese die Bodenplatte 30 bedeckt und das Gehäuse 50 teilweise füllt, wobei sich die Seitenwände des elektrisch isolierenden Abdeckelements 70 in Richtung der Bodenplatte 30 teilweise in die elektrisch isolierende Vergussmasse 60 hinein erstrecken. Ein der Bodenplatte 30 zugewandter unterer Teil der Bauelementanordnung 10 ist nach dem Einfüllen der elektrisch isolierenden Vergussmasse von der elektrisch isolierenden Vergussmasse 60 bedeckt, und ein oberer Teil der Bauelementanordnung 10, welcher aus der elektrisch isolierenden Vergussmasse 60 herausragt, ist wenigstens teilweise von den Seitenwänden des elektrisch isolierenden Abdeckelements 70 umgeben.

Gemäß einer Ausführungsform wird die elektrisch isolierende Vergussmasse 60 in das Gehäuse 50 eingefüllt, nachdem das elektrisch isolierende Abdeckelement 70 über der Bauelementanordnung 10 und dem Klemmsystem angeordnet wurde. Anschließend kann die elektrisch isolierende Vergussmasse 60 ausgehärtet werden. Gemäß einer alternativen Ausführungsform wird die elektrisch isolierende Vergussmasse 60 in das Gehäuse 50 eingefüllt, bevor das elektrisch isolierende Abdeckelement 70 über der Bauelementanordnung 10 und dem Klemmsystem angeordnet wurde. Das heißt, das elektrisch isolierende Abdeckelement 70 kann so über der Bauelementanordnung 10 angeordnet werden, dass es sich teilweise in die bereits im Gehäuse 50 befindliche elektrisch isolierende Vergussmasse 60 hinein erstreckt. Die elektrisch isolierende Vergussmasse 60 ist in diesem Beispiel noch flüssig oder zähflüssig, wenn das elektrisch isolierende Abdeckelement 70 über der Bauelementanordnung 10 angeordnet wird. Anschließend kann die elektrisch isolierende Vergussmasse 60 ausgehärtet werden. Unabhängig davon, ob die elektrisch isolierende Vergussmasse 60 vor oder nach dem Anordnen des elektrisch isolierenden Abdeckelements 70 über der Bauelementanordnung 10 in das Gehäuse 50 eingefüllt wird, resultiert das beschriebene Verfahren in der oben beschriebenen Anordnung (vgl. z.B. Figuren 7 und 9).

## Patentansprüche

1. Ein Halbleitermodul (100) weist auf:
ein Gehäuse (50);
eine Bodenplatte (30), welche einen Boden des Gehäuses (50) bildet;
eine in dem Gehäuse (50) und auf der Bodenplatte (30) angeordnete Bauelementanordnung (10);
ein Klemmsystem mit einer Klemmplatte (40) und einem oder mehreren Befestigungselementen (42), wobei die Bauelementanordnung (10) zwischen der Klemmplatte (40) und der Bodenplatte (30) angeordnet ist, und das eine oder die mehreren Befestigungselemente (42) dazu ausgebildet sind, die Klemmplatte (40) in Richtung der Bodenplatte (30) zu ziehen, so dass die Bauelementanordnung (10) mittels der Klemmplatte (40) gegen die Bodenplatte (30) gedrückt wird;
ein elektrisch isolierendes Abdeckelement (70), welches einen Deckel und Seitenwände aufweist, wobei sich der Deckel wenigstens teilweise über eine von der Bauelementanordnung (10) abgewandte Seite der Klemmplatte (40) erstreckt, und sich die Seitenwände von dem Deckel in Richtung der Bodenplatte (30) erstrecken; und
eine elektrisch isolierende Vergussmasse (60), welche die Bodenplatte (30) bedeckt und das Gehäuse (50) teilweise füllt, wobei
sich die Seitenwände des elektrisch isolierenden Abdeckelements (70) in Richtung der Bodenplatte (30) teilweise in die elektrisch isolierende Vergussmasse (60) hinein erstrecken, und
ein der Bodenplatte zugewandter unterer Teil der Bauelementanordnung (10) von der elektrisch isolierenden Vergussmasse (60) bedeckt ist, und ein oberer Teil der Bauelementanordnung (10), welcher aus der elektrisch isolierenden Vergussmasse (60) herausragt, wenigstens teilweise von den Seitenwänden des elektrisch isolierenden Abdeckelements (70) umgeben ist.

2. Halbleitermodul (100) nach Anspruch 1, wobei sich die Seitenwände des elektrisch isolierenden Abdeckelements (70) derart in die elektrisch isolierende Vergussmasse (60) hineinerstrecken, dass die Seitenwände zu weniger als 50%, zu weniger als 25% oder zu weniger als 15% von der elektrisch isolierenden Vergussmasse (60) bedeckt sind.

3. Halbleitermodul (100) nach Anspruch 1 oder 2, wobei die elektrisch isolierende Vergussmasse (60) das Gehäuse (50) zu 80% oder weniger, zu 75% oder weniger, oder zu 65% oder weniger füllt.

4. Halbleitermodul (100) nach einem der Ansprüche 1 bis 3, wobei die Bauelementanordnung (10) aufweist:
ein Halbleiterbauelement (12);
eine auf einer ersten Seite des Halbleiterbauelements (12) angeordnete erste Kontaktscheibe (14), die dazu ausgebildet ist das Halbleiterbauelement (12) elektrisch zu kontaktieren;
eine auf einer zweiten, der ersten gegenüberliegenden Seite des Halbleiterbauelements (12) angeordnete zweite Kontaktscheibe (16), die dazu ausgebildet ist das Halbleiterbauelement (12) elektrisch zu kontaktieren;
eine auf der ersten Seite des Halbleiterbauelements (12) angeordnete Isolierscheibe (22); und
eine auf der zweiten Seite des Halbleiterbauelements (12) angeordnete Druckplatte (24), wobei
die erste Kontaktscheibe (14), die zweite Kontaktscheibe (16) und das Halbleiterbauelement (12) zwischen der Isolierscheibe (22) und der Druckplatte (24) angeordnet sind, und
die erste und die zweite Kontaktscheibe (14, 16) durch den mittels des Klemmsystems ausgeübten Druck zur elektrischen Kontaktierung jeweils gegen das Halbleiterbauelement (12) gepresst werden.

5. Halbleitermodul (100) nach Anspruch 4, wobei die elektrisch isolierende Vergussmasse (60) wenigstens die Isolierscheibe (22), die erste Kontaktscheibe (14), das Halbleiterbauelement (12), und die zweite Kontaktscheibe (16) bedeckt.

6. Halbleitermodul (100) nach Anspruch 4 oder 5, das weiterhin wenigstens ein erstes Anschlussterminal (142) aufweist, welches ein erstes Ende und ein zweites, dem ersten gegenüberliegendes zweites Ende aufweist, wobei das erste Ende mit der ersten Kontaktscheibe (14) verbunden ist, sich das erste Anschlussterminal (142) von der ersten Kontaktscheibe (14) durch das Gehäuse (50) erstreckt, und das zweite Ende auf einer der Bodenplatte (30) abgewandten Seite aus dem Gehäuse (50) herausragt, wobei das elektrisch isolierende Abdeckelement (70) zwischen der Bauelementanordnung (10) und dem ersten Anschlussterminal (142) angeordnet ist.

7. Halbleitermodul (100) nach einem der vorhergehenden Ansprüche, wobei die Bauelementanordnung (10) ein Kontaktelement (18) aufweist, das dazu ausgebildet ist das Halbleiterbauelement (12) elektrisch zu kontaktieren und zwischen der Druckplatte (24) und der zweiten Kontaktscheibe (16) angeordnet ist, und wobei das Kontaktelement (18) zumindest teilweise von der Vergussmasse (60) bedeckt wird.

8. Halbleitermodul (100) nach einem der vorhergehenden Ansprüche, wobei das elektrisch isolierende Abdeckelement (70) aus Keramik oder Kunststoff besteht.

9. Halbleitermodul (100) nach einem der vorhergehenden Ansprüche, wobei der Deckel des elektrisch isolierenden Abdeckelements (70) eine Öffnung oder eine Vertiefung aufweist.

10. Halbleitermodul (100) nach einem der vorhergehenden Ansprüche, wobei ein oberer Teil der Bauelementanordnung (10), welcher aus der elektrisch isolierenden Vergussmasse (60) herausragt, vollständig von den Seitenwänden des elektrisch isolierenden Abdeckelements (70) umgeben ist.

11. Halbleitermodul (100) nach einem der vorhergehenden Ansprüche, wobei das Gehäuse (50) einen Gehäusedeckel aufweist, und wobei der Deckel des elektrisch isolierenden Abdeckelements (70) an dem Gehäusedeckel befestigt ist oder durch einen Abschnitt des Gehäusedeckels gebildet wird.

12. Verfahren zum Herstellen eines Halbleitermoduls (100), wobei das Verfahren aufweist
Anordnen einer Bauelementanordnung (10) auf einer Bodenplatte (30), wobei die Bodenplatte (30) den Boden eines Gehäuses (50) bildet;
Anordnen einer Klemmplatte (40) eines Klemmsystems auf der Bauelementanordnung (10), so dass die Bauelementanordnung (10) zwischen der Klemmplatte (40) und der Bodenplatte (30) angeordnet ist;
Befestigen der Klemmplatte (40) an der Bodenplatte (30) mittels einem oder mehrerer Befestigungselemente (42) derart, dass das eine oder die mehreren Befestigungselemente (42) die Klemmplatte (40) in Richtung der Bodenplatte (30) ziehen, so dass die Bauelementanordnung (10) mittels der Klemmplatte (40) gegen die Bodenplatte (30) gedrückt wird;
Anordnen eines elektrisch isolierenden Abdeckelements (70) über der Bauelementanordnung (10) und dem Klemmsystem, wobei das elektrisch isolierende Abdeckelement (70) einen Deckel und Seitenwände aufweist, wobei das elektrisch isolierende Abdeckelement (70) derart angeordnet wird, dass sich der Deckel wenigstens teilweise über eine von der Bauelementanordnung (10) abgewandte Seite der Klemmplatte (40) erstreckt, und sich die Seitenwände von dem Deckel in Richtung der Bodenplatte (30) erstrecken; und
Einfüllen einer elektrisch isolierenden Vergussmasse (60) in das Gehäuse, derart, dass diese die Bodenplatte (30) bedeckt und das Gehäuse (50) teilweise füllt, wobei
sich die Seitenwände des elektrisch isolierenden Abdeckelements (70) in Richtung der Bodenplatte (30) teilweise in die elektrisch isolierende Vergussmasse (60) hinein erstrecken, und
ein der Bodenplatte zugewandter unterer Teil der Bauelementanordnung (10) von der elektrisch isolierenden Vergussmasse (60) bedeckt ist, und ein oberer Teil der Bauelementanordnung (10), welcher aus der elektrisch isolierenden Vergussmasse (60) herausragt, wenigstens teilweise von den Seitenwänden des elektrisch isolierenden Abdeckelements (70) umgeben ist.

13. Verfahren nach Anspruch 12, wobei die elektrisch isolierende Vergussmasse (60) in das Gehäuse (50) eingefüllt wird, nachdem das elektrisch isolierende Abdeckelement (70) über der Bauelementanordnung (10) und dem Klemmsystem angeordnet wurde.

14. Verfahren nach Anspruch 12, wobei die elektrisch isolierende Vergussmasse (60) in das Gehäuse (50) eingefüllt wird, bevor das elektrisch isolierende Abdeckelement (70) über der Bauelementanordnung (10) und dem Klemmsystem angeordnet wurde.
